Europäisches Patentamt

European Patent Office

Office européen des brevets

(11) Veröffentlichungsnummer: **0 069 789**
**B1**

(12) # EUROPÄISCHE PATENTSCHRIFT

(45) Veröffentlichungstag der Patentschrift:
06.11.85

(51) Int. Cl.⁴: **H 03 K 11/00**

(21) Anmeldenummer: **81105385.9**

(22) Anmeldetag: **10.07.81**

(54) Integrierte Schaltung für eine Eingabe-Tastatur elektronischer Geräte.

(43) Veröffentlichungstag der Anmeldung:
**19.01.83 Patentblatt 83/3**

(45) Bekanntmachung des Hinweises auf die Patenterteilung:
**06.11.85 Patentblatt 85/45**

(84) Benannte Vertragsstaaten:
**DE FR GB IT NL**

(56) Entgegenhaltungen:
**DE - A - 1 549 122**
**DE - A - 2 035 646**
**DE - A - 2 333 879**
**US - A - 3 717 871**

**ELEKTRONIK, Band 1, Nr. 1, Januar 1979, MÜNCHEN
(DE), M. OHSMANN: "Einfache Tastaturschaltung",
Seite 68**

(73) Patentinhaber: **Deutsche ITT Industries GmbH,
Hans-Bunte-Strasse 19 Postfach 840, D-7800 Freiburg
(DE)**
(84) Benannte Vertragsstaaten: **DE**

(73) Patentinhaber: **ITT INDUSTRIES INC., 320 Park Avenue,
New York, NY 10022 (US)**
(84) Benannte Vertragsstaaten: **FR GB IT NL**

(72) Erfinder: **Backes, Reiner, Dipl.-Ing., Kehler Strasse 42,
D-7800 Freiburg/Brg. (DE)**

(74) Vertreter: **Morstadt, Volker, Dipl.-Ing., c/o Deutsche ITT
Industries GmbH Patent/Lizenzabteilung
Postfach 840 Hans-Bunte-Strasse 19,
D-7800 Freiburg/Brsg. (DE)**

**Beschreibung**

Die Erfindung betrifft eine integrierte Schaltung für eine Eingabe-Tastatur elektronischer Geräte mit in n Spalten und m Zeilen angeordneten, zwei Anschlüsse aufweisenden Tastschaltern, wobei jeder Tastschalter bei Betätigung eine der jeweiligen Spalte zugeordnete Spaltenleitung mit einer der jeweiligen Zeile zugeordneten Zeilenleitung direkt verbindet, jede Spaltenleitung mit dem Eingang eines ersten Spalteninverters verbunden ist und über ein erstes Widerstandselement an einem konstanten Potential liegt, jede Zeilenleitung über den getakteten Strompfad eines Zeilentransistors am Schaltungsnullpunkt liegt und ihr ein Zeileninverter zugeordnet ist (vergleiche den Oberbegriff des Anspruchs 1, der aus der Offenlegungs/Auslegeschrift DE 2854934 A1/B2 bekannt ist).

Bei der bekannten Anordnung liegen die jeder Spaltenleitung zugeordneten Widerstandselemente am Schaltungsnullpunkt und die ersten Spalteninverter sind über elektronische Schalter, die von einem Taktsignal periodisch geöffnet und geschlossen werden, mit der jeweiligen Spaltenleitung verbunden, so dass diese nur zeitweise – während die Schalter geschlossen sind – miteinander verbunden sind. Bei der bekannten Anordnung ist ferner den einzelnen Zeilenleitungen jeweils ein Zeileninverter zugeordnet, die ebenfalls nur zeitweise mit den Zeilenleitungen in Verbindung stehen, nämlich dann, wenn die von einem zum erwähnten Taktsignal inversen Taktsignal gesteuerten elektronischen Schalter geschlossen sind. Die bekannte Anordnung arbeitet im Ruhezustand, also ohne gedrückte Tastschalter, statisch und bei Drücken eines Tastschalters dynamisch, wobei die Anzahl der Bauelemente minimal ist. Die bekannte Anordnung liefert ferner bezüglich der Spalten ein Eins-aus-n-codiertes und bezüglich der Zeilen, ein Eins-aus-m-codiertes Signal.

In bestimmten Anwendungsfällen ist es jedoch erforderlich, ein Eins-aus-m-mal-n-codiertes Signal zu erzeugen. Ausgehend von dem eingangs genannten Stand der Technik besteht die Aufgabe der in den Ansprüchen gekennzeichneten Erfindung darin, eine entsprechende integrierte Schaltung anzugeben, die ebenfalls mit einer möglichst minimalen Anzahl von Bauelementen auskommen soll. Ein Vorteil der Erfindung besteht darin, dass die verwendete Matrix mit den an den gekennzeichneten Stellen angeordneten Matrixtransistoren die Struktur eines Festwertspeichers hat, so dass sich diese Matrix, insbesondere bei Realisierung mit Isolierschicht-Feldeffekttransistoren, besonders platzsparend integrieren lässt.

Diese Aufgabe wird durch die im Anspruch 1 gekennzeichnete Schaltung gelöst.

Die Erfindung wird nun anhand der Zeichnung näher erläutert.

Fig. 1 zeigt teilweise schematisch das Schaltbild eines Ausführungsbeispiels der Erfindung, und

Fig. 2 zeigt vergrössert dargestellt die in Fig. 1 vorhandene Matrix.

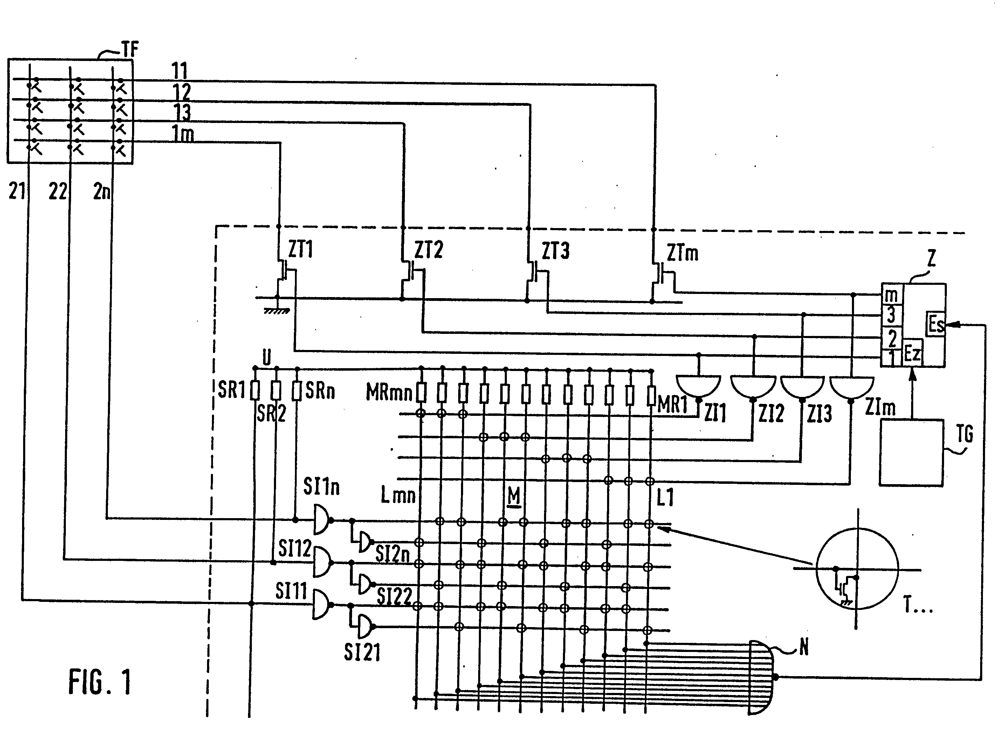

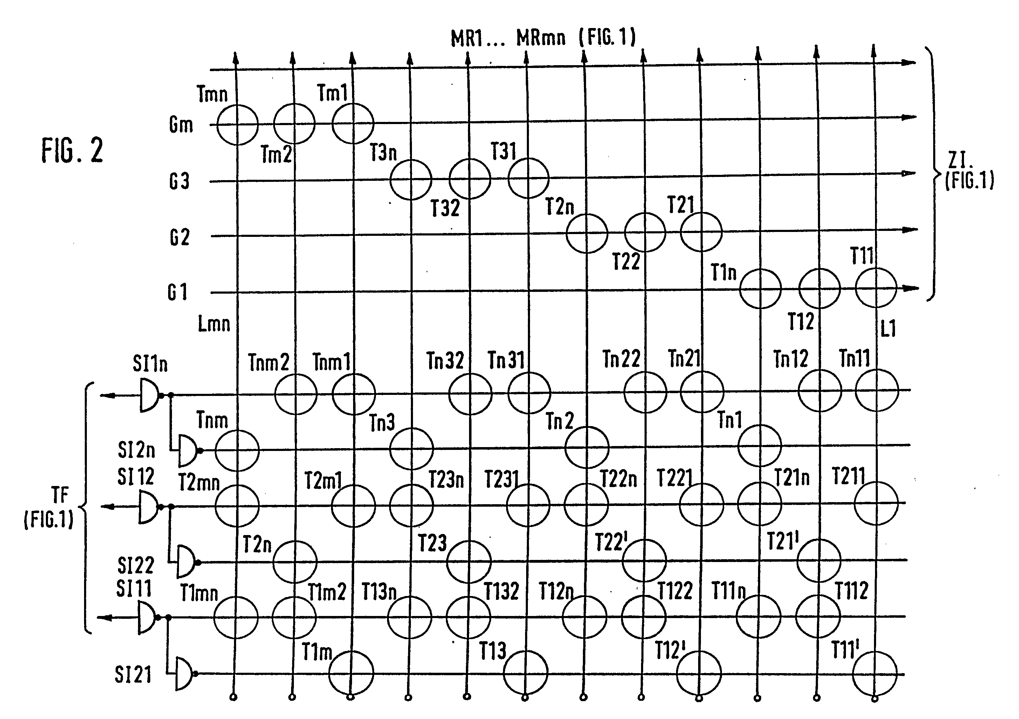

Im Schaltbild eines Ausführungsbeispiels der Erfindung nach Fig. 1 ist die Eingabe-Tastatur TF schematisch mit m Zeilenleitungen 11, 12, 13, 1m und n Spaltenleitungen 21, 22, 2n gezeigt, wobei in Fig. 1 m = 4 und n = 3 ist. An den jeweiligen Kreuzungspunkten ist in bekannter Weise jeweils ein Tastschalter angeordnet, der beim Betätigen die jeweilige Zeilen- mit der jeweiligen Spaltenleitung direkt verbindet.

Die jeweilige Zeilenleitung 11, 12, 13, 1m ist über den getakteten Strompfad des zugehörigen Zeilentransistors ZT1, ZT2, ZT3, ZTm mit dem Schaltungsnullpunkt verbunden. Die Zeilentransistoren ZT1–ZTm sind mit den Zählerstandausgängen 1, 2, 3, m des Zählers Z verbunden, dessen Zähleingang Ez am Ausgang des Taktgenerators TG liegt. Somit werden die Zeilentransistoren ZT1–ZTm nacheinander von den Zählerstandausgängen 1–m leitend gesteuert. Dadurch wird, wenn die Betätigung eines Tastschalters beispielsweise die Zeilenleitung 1m und die Spaltenleitung 2n miteinander verbunden werden, der entsprechende Zeilentransistor ZT1 mit dem ersten Widerstandselement SRn zu einem Inverter zusammengeschaltet und das Potential an deren Verbindungspunkt auf das des Schaltungsnullpunktes durchgeschaltet (= L-Pegel).

Jeder Spaltenleitung 21–2n ist ein solches Widerstandselement SR1–SRn zugeordnet, den Spaltenleitungen 21, 22 also die Widerstandselemente SR1, SR2. Die Spaltenleitungen 21–2n liegen auch jeweils am Eingang des ersten Spalteninverters SI11, SI12, SI1n.

Die Zählerstandausgänge 1...m des Zählers Z sind auch mit den Eingängen der jeweiligen Zeileninverter ZI1, ZI2, ZI3, ZIm verbunden. Ferner ist die Matrix M aus m Leitungsgruppen G1, G2, G3, Gm (vergleiche Fig. 2) vorgesehen, wobei jede Leitungsgruppe G1–Gm n Matrixleitungen hat. In den Fig. 1 und 2 sind also 12 derartige Matrixleitungen L1...Lmn vorhanden; diese sind über die zweiten Widerstandselemente MR1–MRmn mit der Betriebsspannung U verbunden. An diesen Matrixleitungen tritt das Ausgangssignal, also der Eins-aus-m-mal-n-Code auf.

Die Ausgänge der Zeileninverter ZI1–ZIm sind jeweils mit dem Gate von Matrixtransistoren verbunden, über deren gesteuerten Strompfad das zugehörige zweite Widerstandselement MR1–MRmn am Schaltungsnullpunkt liegt, wobei zu jedem Zeileninverter ZI1–ZIm eine Leitungsgruppe G1–Gm gehört. Im Ausführungsbeispiel der Fig. 1 und 2, bei dem n = 3 ist, gehören also zu jedem Zeileninverter drei Matrixtransistoren T11–Tmn in jeder Leitungsgruppe G1–Gm. Die Fig. 2 zeigt somit für die Leitungsgruppen G1, G2, G3, Gm die Matrixtransistoren T11, T12, T1n; T21, T22, T2n; T31, T32, T3n; Tm1, Tm2, Tmn.

In ähnlicher Weise sind die Ausgänge der ersten und zweiten Spalteninverter SI11–SI1n, SI12–SI2n über weitere Matrixtransistoren mit den Leitungsgruppen G1–Gm verbunden. Die Gesetzmässigkeit dieser Verbindung besteht darin, dass der Ausgang jedes zweiten Spalteninverters SI21–SI2n an den Gates von m weiteren, jeweils zu einer Leitungsgruppe G1–Gm entsprechend gehörenden Matrixtransistoren liegt. Aus Fig. 2 ist zu entnehmen, dass der Ausgang des zur ersten Spaltenleitung 21 gehörenden zweiten Spalteninverters SI21 in den Leitungsgruppen G1–Gm mit den Gates der jeweils der ersten Leitung zugeordneten Transistoren verbunden ist, also die Matrixtransistoren T11', T12', T13, T1m steuert. In ähnlicher Weise steuert der zur zweiten Spaltenleitung 22 gehörende zweite Spalteninverter SI22 die jeweils zweite Leitung in den Leitungsgruppen G1–Gm über die Matrixtransistoren T21', T22a', T23, T2n, während der der n-ten Spaltenleitung 2n zugeordnete zweite Spalteninverter SI2n die der jeweils n-ten Leitung in jeder Leitungsgruppe G1–Gm zugeordneten Matrixtransistoren Tn1, Tn2, Tn3, Tnm ansteuert.

Jeder Ausgang der ersten Spalteninverter SI11–SI1n liegt am Gate von m mal (n-1) weiterer Matrixtransistoren, die denjenigen Leitungen jeder Leitungsgruppe G1–Gm zugeordnet sind, die von den von den zweiten Spalteninvertern SI21–SI2n gesteuerten weiteren Matrixtransistoren noch freigelassen sind. In Fig. 2 sind dies bezüglich des der ersten Spaltenleitung 21 zugeordneten ersten Spalteninverters SI11 die Matrixtransistoren T112, T11n; T122, T12n; T132, T13n; T1m2, T1mn. Der der zweiten Spaltenleitung 22 zugeordnete erste Spalteninverter SI12 ist mit den Gates der Matrixtransistoren T211, T21n; T221, T22n; T231, T23n; T2m1, T2mn verbunden. Schliesslich steuert der erste Spalteninverter SI1n die Gates der Matrixtransistoren Tn11, Tn12; Tn21, Tn22; Tn31, Tn32; Tnm1, Tnm2.

Jede der Leitungen L1–Lmn der Matrix M liegt an einem Eingang des NOR-Gatters N, dessen Ausgang den Freigabeeingang Es des Zählers Z ansteuert.

In dem oben angenommenen Betriebsfall, bei dem die Zeilenleitung 1m und die Spaltenleitung 2n durch Tastenfeldbetätigung miteinander verbunden sind, bewirkt das Potential des Schaltungsnullpunkts (= L-Pegel) am Eingang des ersten Spalteninverters SI1n, dass an dessen Ausgang das Potential der Betriebsspannung U (= H-Pegel) auftritt, das durch den zweiten Spalteninverter SI2n wiederum in einen L-Pegel invertiert wird.

Andererseits wird der H-Pegel am Zählerstandausgang 1 des Zählers Z durch den Zeileninverter ZI1 in einen L-Pegel invertiert, und die dem Widerstandselement MRmn zugeordneten Matrixtransistoren T1mn, T2mn sind durch die an den Ausgängen der ersten Spalteninverter SI11, SI12 auftretenden L-Pegel ebenfalls gesperrt, so dass die Leitung Lmn einen H-Pegel führt.

Wird nun gleichzeitig ein anderer Tastschalter des Tastenfelds TF betätigt, beispielsweise der links neben dem betrachteten in der rechten unteren Ecke des Tastenfeldes TF angeordnet liegende, werden also zusätzlich die Zeilenleitung 1m und die Spaltenleitung 22 miteinander verbunden, so tritt auch am Eingang des ersten Spalteninverters SI12 ein L-Pegel und an dessen Ausgang ein H-Pegel auf, so dass der Matrixtransistor T2mn durchgesteuert wird und die Leitung Lmn einen L-Pegel annimmt. Somit haben alle Leitungen der Matrix M den Anfangs-L-Pegel wieder angenommen, woraus sich ohne weiteres eine Fehlbedienungsüberwachung im Sinne einer Sicherung gegen Mehrfachbetätigung ergibt.

Der an der Leitung Lmn bei der erwähnten Tastenbetätigung auftretende H-Pegel führt im übrigen am Ausgang des NOR-Gatters·N zu einem L-Pegel, der den Zähler Z stoppt.

Im Ausführungsbeispiel nach Fig. 1 sind die Zeilentransistoren ZT1–ZTm und die Matrixtransistoren T11'–Tmn als Isolierschicht-Feldeffekttransistoren gezeichnet, welche Realisierungsmöglichkeit der Erfindung besonders vorteilhaft ist. In diesem Falle werden selbstverständlich auch die ersten und die zweiten Widerstandselemente SR1–SRn, MR1–MRmn mittels Isolierschicht-Feldeffekttransistoren realisiert. Besonders vorteilhaft ist es, einerseits die die Zeilen- und die Matrixtransistoren realisierenden Isolierschicht-Feldeffekttransistoren und die Schalttransistoren der vorhandenen Inverter als n-Kanal-Anreicherungstyp-Transistoren auszuführen und andererseits die Lastelemente der Inverter und die Widerstandselemente als n-Kanal-Verarmungstyp-Transistoren. Das Gate der letzteren Transistoren ist dann mit dem jeweiligen Inverterausgang verbunden.

**Patentansprüche**

1. Integrierte Schaltung für eine Eingabe-Tastatur (TF) elektronischer Geräte mit in n Spalten und m Zeilen angeordneten, zwei Anschlüsse aufweisenden Tastschaltern, wobei jeder Tastschalter bei Betätigung eine der jeweiligen Spalte zugeordnete Spaltenleitung (21–2n) mit einer der jeweiligen Zeile zugeordneten Zeilenleitung (11–1m) direkt verbindet, jede Spaltenleitung (21–2n) mit dem Eingang eines ersten Spalteninverters (SI11–SI1n) verbunden ist und über ein erstes Widerstandselement (SR1–SRn) an einem konstanten Potential liegt, jede Zeilenleitung (11–1m) über den getakteten Strompfad eines Zeilentransistors (ZT1–ZTm) am Schaltungsnullpunkt liegt und ihr ein Zeileninverter (ZI1–ZIm) zugeordnet ist, gekennzeichnet durch folgende Merkmale:

– jede Spaltenleitung (21–2n) ist mit dem Eingang des ersten Spalteninverters (SI11–SI1n) dauernd verbunden,

– die jeder Spalte zugeordneten ersten Widerstandselemente (SR1–SRn) liegen an der Betriebsspannung (U),

– die Strompfade der Zeilentransistoren (ZT1–ZTm) sind mit den Zeilenleitungen (11–1m) dauernd verbunden,

– die Gates der Zeilentransistoren (ZT1–ZTm) liegen der Reihe nach an den Zählerstandausgängen (1–m) eines auf m zählenden Zählers (Z), dessen Zähleingang (Ez) mit dem Ausgang eines Taktgenerators (TG) verbunden ist,

– mit jedem Zählerstandausgang (1–m) ist der Eingang des entsprechenden Zeileninverters (ZI1–ZIm) verbunden,

– es ist eine Matrix (M) mit m Leitungsgruppen (G1–Gm) mit je n Leitungen (L1–Lmn) vorgesehen, die über jeweils ein zweites Widerstandselement (MR1–MRmn) an der Betriebsspannung (U) liegen und an denen ein Ein-aus-m-mal-n-Code entsteht,

– die Ausgänge der Zeileninverter (ZI1–ZIm) sind jeweils mit den Gates von Matrixtransistoren (T11–Tmn) verbunden, über deren gesteuerte Strompfade die zugehörigen zweiten Widerstandselemente (MR1–MRmn) am Schaltungsnullpunkt liegen, wobei zu jedem Zeileninverter (ZI1–ZIm) eine der Leitungsgruppen (G1–Gm) gehört,

– jeder Ausgang des ersten Spalteninverters (SI-11–SI1n) ist mit dem Eingang eines zweiten Spalteninverters (SI21–SI2n) verbunden, dessen Ausgang an den Gates von m weiteren und jeweils zu einer Leitung jeder der m Leitungsgruppen (G1–Gm) gehörenden Matrixtransistoren (T11'–Tnm) liegt, über deren gesteuerte Strompfade die zugehörigen zweiten Widerstandselemente am Schaltungsnullpunkt liegen,

– jeder Ausgang des ersten Spalteninverters (SI-11–SI1n) liegt am Gate von m mal (n–1) weiteren Matrixtransistoren, die denjenigen Leitungen jeder Leitungsgruppe (G1–Gm) zugeordnet sind, die von den von den zweiten Spalteninvertern (SI-21–SI2n) gesteuerten weiteren Matrixtransistoren noch freigelassen sind und über deren gesteuerte Strompfade die zugehörigen zweiten Widerstandselemente am Schaltungsnullpunkt liegen und

– jede Leitung (L1–Lmn) der Matrix (M) liegt an einem der Eingänge eines NOR-Gatters (N), dessen Ausgang mit dem Freigabeeingang (Es) des Zählers (Z) verbunden ist.

2. Integrierte Schaltung nach Anspruch 1, dadurch gekennzeichnet, dass die Transistoren Isolierschicht-Feldeffekttransistoren und die Widerstandselemente entsprechend geschaltete Isolierschicht-Feldeffekttransistoren sind.

3. Schaltungsanordnung nach Anspruch 2, dadurch gekennzeichnet, dass die Widerstandselemente n-Kanal-Verarmungstyp-Transistoren, dass die Inverter solche mit n-Kanal-Anreicherungstyp-Schalttransistoren und n-Kanal-Verarmungstyp-Lasttransistoren sind und dass die restlichen Isolierschicht-Feldeffekttransistoren n-Kanal-Anreicherungstyp-Transistoren sind.

**Claims**

1. Integrated circuit for a keyboard (TF) of electronic apparatus, comprising pushbutton keys arranged in n columns and m rows, each pushbutton key having two terminals and, when being actuated directly, connects one column line (21–2n) associated with the respective column, to one row line (11–1m) associated with the respective row, with each column line (21–2n) being connected to the input of a first column inverter (SI11–SI1n) and, across a first resistance element (SR1–SRn), to a constant potential, with each row line (11–1m), via the clocked current path of a row transistor (ZT1–ZTm), being connected to the zero point of the circuit, with a row inverter (ZI1–ZIm)

being associated therewith, characterized by the following features:

– each column line (21–2n) is permanently connected to the input of the first column inverter (SI11–SI1n),

– the first resistance elements (SR1–SRn) as associated with each column, are connected to the operating voltage (U),

– the current paths of the row transistors (ZT1–ZTm) are permanently connected to the row lines (11–1m),

– the gates of the row transistors (ZT1–ZTm) are successively connected to the counter reading outputs (1–m) of a counter (Z) counting up to m, with the counting input (Ez) thereof being connected to the output of a clock pulse generator (TG),

– to each counter reading output (1–m) there is connected the input of the corresponding row inverter (ZI1–ZIm),

– there is provided a matrix (N) having m line groups (G1–Gm) of n lines each (L1–Lmn) which, each via a second resistance element (MR1–MRmn), are connected to the operating voltage (U), and at which there appears a 1-ex-m-times-n code,

– the outputs of said row inverters (ZI1–ZIm) are respectively connected to the gates of matrix transistors (T11–Tmn) across whose controlled current paths the associated resistance elements (MR1–MRmn) are connected to the zero point of the circuit, with each time one of the line groups (G1–Gm) being associated with each of said row inverters (ZI1–ZIm),

– each output of the first column inverter (SI-11–SI1n) is connected to the input of a second column inverter (SI21–SI2n), with the output thereof being connected to the gates of m further matrix transistors (T11'–Tnm) and associated with each time one line of each of said m line groups (G1–Gm) via whose controlled current paths the associated second resistance elements are connected to the zero point of the circuit,

– each output of the first column inverter (SI-11–SI1n) is connected to the gates of m times (n–1) further matrix transistors which are associated with those particular lines in each line group (G1–Gm) which are still left out by said further matrix transistors as controlled by said second column inverters (SI21–SI2n), and via whose controlled current paths the associated second resistance elements are connected to the zero point of the circuit, and

– each line (L1–Lmn) of said matrix (M) is connected to one of the inputs of a NOR gate (N), with the output thereof being connected to the enable input (Es) of said counter (Z).

2. An integrated circuit as claimed in claim 1, characterized in that said transistors are insulated-gate field-effect transistors, and that said resistance elements are correspondingly connected insulated-gate field-effect transistors.

3. A circuit as claimed in claim 2, characterized in that said resistance elements are n-channel depletion type transistors, that said inverters are such ones comprising switching transistors of the n-channel enhancement type and load transistors of the n-channel depletion type, and that the remaining insulated-gate field-effect transistors are n-channel enhancement type transistors.

## Revendications

1. Circuit intégré destiné à un clavier d'entrée (TF) pour appareils électroniques, comportant des commutateurs à touche disposés selon n colonnes et m lignes et possédant deux points de raccordement, tels que, lorsqu'il est actionné, chaque commutateur à touche met directement en relation le fil de colonne (21–2n) affecté à la colonne correspondante avec le fil de ligne (11–1m) affecté à la ligne correspondante, chaque fil de colonne (21–2n) étant relié à l'entrée d'un premier inverseur de colonne (SI11–SI1n) et raccordé à un potentiel constant par un premier élément de résistance (SR1–SRn), chaque fil de ligne (11–1m) étant relié au point zéro du circuit par le trajet de courant commandé d'un transistor de ligne (ZT1–ZTm) auquel un inverseur de ligne (ZI1–ZIm) est affecté, caractérisé en ce que:

– chaque fil de colonne (21–2n) est relié en permanence à l'entrée du premier inverseur de colonne (SI11–SI1n),
– les premiers éléments de résistance (SR1–SRn) affectés à chaque colonne sont raccordés à la tension d'alimentation (U),
– le trajet de courant des transistors de ligne (ZT1–ZTm) est relié en permanence aux fils de lignes (11–1m),
– les grilles des transistors de ligne (ZT1–ZTm) sont raccordées dans l'ordre aux sorties des positions de comptage (1m) d'un compteur (Z) comptant jusqu'à m dont l'entrée de comptage (Ez) est reliée à la sortie d'un générateur du base de temps (TG),
– l'entrée de l'inverseur de ligne correspondant (ZT1–ZTm) est reliée à chaque sortie de position de comptage (1–m),
– il est prévu une matrice (M) avec m groupes de fils (G1–Gm) de chacun n fils (L1–Lmn) qui sont raccordés à la tension d'alimentation (U) par l'intermédiaire d'un second élément de résistance (MR1–TMRmn),
– les sorties des inverseurs de ligne (ZI1–ZIm) sont reliées aux grilles des transistors de matrice (T11–Tmn) par le trajet de courant desquels les seconds éléments de résistance correspondants (MR1–MRmn) sont reliés au point zéro du circuit, l'un des groupes de fils (G1–Gm) appartenant à chaque inverseur de ligne (ZI1–ZIm),
– chaque sortie du premier inverseur de colonne (SI11–SIn) est reliée à l'entrée d'un second inverseur de colonne (SI21–SI2n) dont la sortie est reliée aux grilles de m transistors de matrice supplémentaires (T11'–Tnm) appartenant chacun à un fil de chacun des m groupes de fils (G1–Gm), par le trajet de courant commandé desquels les seconds éléments de résistance correspondants sont reliés au point zéro du circuit,
– chaque sortie du premier inverseur de colonne (SI11–SI1n) est reliée à la grille de m fois (n-1) transistors de matrice supplémentaires qui sont affectés aux fils de chaque groupe (G1–Gm) qui sont laissés libres par les transistors supplémentaires de matrice commandés par les seconds inverseurs de colonne (SI21–SI2n) et par le trajet de courant desquels les seconds éléments de résistance correspondants sont reliés au point zéro du circuit,
– chaque fil (L1–Lmn) de la matrice (M) est raccordé à l'une des entrées d'une porte NOR (N) dont la sortie est reliée à l'entrée de validation (Es) du compteur (Z).

2. Circuit intégré conforme à la revendication 1, caractérisé en ce que les transistors sont des transistors à effet de champ à grille isolée et en ce que les éléments de résistance sont des transistors à effet de champ à grille isolée câblés en conséquence.

3. Circuit intégré conforme à la revendication 2, caractérisé en ce que les éléments de résistance sont des transistors de type à canal N à appauvrissement, en ce que les inverseurs sont des transistors de commutation de type à canal N à enrichissement et des transistors de charge de type à canal N à appauvrissement, et en ce que les transistors à effet de champ à grille isolée restants sont des transistors de type à canal N à enrichissement.

FIG. 1

FIG. 2

MR1... MRmn (FIG.1)

ZI.
(FIG.1)

TF
(FIG.1)

0069789